# EUROPÄISCHE PATENTSCHRIFT

(11) **EP 2 033 002 B1**
(45) Veröffentlichungstag und Bekanntmachung des Hinweises auf die Patenterteilung: **21.04.2010**
(21) Anmeldenummer: 07786355.3
(22) Anmeldetag: 26.07.2007
(51) Int. Cl.: G01R 31/28

(54) **KONTAKTIERVORRICHTUNG ZUM TESTEN VON ELEKTRONISCHEN BAUELEMENTEN UNTER BESTIMMTEN TEMPERATURBEDINGUNGEN**
CONTACTING DEVICE FOR TESTING ELECTRONIC COMPONENTS UNDER SPECIFIC TEMPERATURE CONDITIONS
DISPOSITIF DE CONTACT POUR TESTER DES COMPOSANTS ÉLECTRONIQUES DANS DES CONDITIONS DE TEMPÉRATURE DÉFINIES

(30) Priorität: 03.08.2006 DE 102006036291
(43) Veröffentlichungstag der Anmeldung: 11.03.2009
(73) Patentinhaber: Multitest elektronische Systeme GmbH, 83026 Rosenheim (DE)
(72) Erfinder: PÖTZINGER, Johann, 83730 Fischbachau (DE)
(74) Vertreter: Bauer, Friedrich
(86) Internationale Anmeldenummer: PCT/EP2007/006637
(87) Internationale Veröffentlichungsnummer: WO 2008/014923

(56) Entgegenhaltungen:
- US-B1- 6 437 593
- US-B1- 6 608 497

## Beschreibung

Die Erfindung betrifft eine Kontaktiervorrichtung zum Testen von elektronischen Bauelementen unter bestimmten Temperaturbedingungen gemäß dem Oberbegriff des Anspruches 1.

Elektronische Bauelemente wie beispielsweise IC's werden bekannterweise vor ihrer Montage auf Leiterplatten oder vor dem Einbau in ein bestimmtes Gerät elektrischen und/ oder mechanischen Tests, auch unter extremen Temperaturbedingungen von beispielsweise -60° bis +160°C, unterzogen, um die Funktionsfähigkeit und Zuverlässigkeit der elektronischen Bauelemente unter diesen Bedingungen zu testen. Die Bauelemente werden hierbei im Handhabungsautomaten ("Handler") in der gewünschten Weise temperiert und von diesem einer Kontaktiervorrichtung zugeführt, die sich zwischen dem Handhabungsautomaten und der Testvorrichtung befindet.

Bei der Kontaktiervorrichtung handelt es sich üblicherweise um die Kombination eines Kontaktierboards (DUT-Board) und mindestens eines Kontaktsockels, der handlerseitig am Kontaktierboard angebracht ist. Am Kontaktsockel sind die Kontaktelemente gehaltert, bei denen es sich üblicherweise um Kontaktstifte (Kontaktpins) oder Kontaktfedern handelt. Die Kontaktelemente schaffen einerseits testerseitig einen elektrischen Kontakt zum Kontaktierboard und damit zur Testvorrichtung und andererseits handlerseitig einen Kontakt zu den zugeführten, zu testenden elektronischen Bauelementen.

Dieser Aufbau erlaubt grundsätzlich eine hohe Flexibilität. Testerseitig kann die Kontaktierung durch das Kontaktierboard geometrischen Erfordernissen der Testvorrichtung angepasst werden. Handlerseitig kann der Kontaktsockel entsprechend den geometrischen Erfordernissen verschiedener Bauelemente angepasst werden. Es ist jedoch nicht zwingend, ein Kontaktierboard und einen Kontaktsockel aus zwei unterschiedlichen Elementen zu fertigen und zu betrachten, weshalb diese zusammen zweckmäßigerweise als Kontaktiervorrichtung bezeichnet werden können. Die Kontaktiervorrichtung kann also ein-, zwei-, drei- oder mehrelementig aufgebaut sein. Ein zweielementiger Aufbau aus Kontaktierboard und Kontaktsockel hat sich allerdings bewährt.

Insbesondere bei elektronischen Bauelementen, die selbst für die Temperaturmessung eingesetzt werden, ist es erforderlich, dass während des Tests dieser elektronischen Bauelemente genaue Temperaturbedingungen eingehalten werden. Sowohl Hersteller elektronischer Geräte als auch Hersteller von elektronischen Bauelementen definieren die erforderliche Genauigkeit beim Temperaturtest von elektronischen Bauelementen, damit ein erfolgreicher Einsatz gewährleistet ist. Hierbei tritt das Problem auf, dass die Temperatur des Halbleiterplättchens ("Die"), auf die es maßgebend ankommt, von der Temperatur der Bausteinummantelung abweichen kann. Dies kann insbesondere während des Testvorgangs durch die Kontaktelemente der Kontaktiervorrichtung verursacht werden, da die Kontaktelemente mit der Testvorrichtung verbunden sind, die üblicherweise eine der Raumtemperatur entsprechende Temperatur von beispielsweise 20°C aufweist, wodurch die Temperatur der Kontaktelemente beeinflusst wird. Die elektrische Verbindung von den Kontaktelementen bis zur Testvorrichtung erfolgt nämlich zweckmäßigerweise über elektrisch gut leitende Materialien, die eine entsprechend hohe Wärmeleitfähigkeit haben. Wenn die Testvorrichtung bei einer Raumtemperatur von 20°C also in elektrisch leitendem Kontakt mit einem auf beispielsweise -60° oder +160°C temperierten Bauelement gebracht wird, so erfolgt zwangsweise ein Wärmeaustausch über diese elektrischen Leitungen. Dabei erfolgt die Wärmeübertragung direkt auf das Halbleiterplättchen, ohne dass die bisher übliche Temperierung der Ummantelung des Bauelements diesen Effekt in jedem Fall befriedigend ausgleichen könnte. Hierdurch können die Testergebnisse verfälscht werden.

Aus der US 2004/0077200 A1 ist eine Kontaktiervorrichtung gemäß dem Oberbegriff des Anspruchs 1 mit einem in der Form eines Hohlprofils ausgebildeten Kontaktsockel bekannt, der auf einem Kontaktierboard befestigt ist. An der Rückseite des Kontaktierboards ist ein Abdeckkörper befestigt, der zusammen mit dem Kontaktierboard eine Fluidzuführkammer und eine Fluidabführkammer umschließt. Fluidzuführkammer und Fluidabführkammer sind über Öffnungen, die im Kontaktierboard vorgesehen sind, mit dem Hohlraum des Kontaktsockels verbunden, so dass temperiertes Fluid in den Hohlraum des Kontaktsockels eingeleitet und sämtliche Kontaktelemente gleichzeitig temperiert werden. Nachteilig ist hierbei jedoch, dass es mit der bekannten Kontaktiervorrichtung nicht möglich ist, auf unterschiedliche Temperierungsanforderungen einzelner Kontaktelemente oder Kontaktelementgruppen zu reagieren. Die gewünschten Temperaturbedingungen an den Kontaktelementen können somit nicht immer eingehalten werden, worunter die Testgenauigkeit leiden kann. Darüber hinaus wird der Bereich auf der Rückseite des Kontaktierboards hinter dem Kontaktsockel durch den Abdeckkörper blockiert, so dass dieser Bereich nicht für Durchkontaktierungen bzw. zum Anschluss von elektrischen Leitungen verwendet werden kann.

Aus der US-6,608,497 B1 ist eine Kontaktiervorrichtung zum elektrischen Testen von elektronischen Bauelementen unter bestimmten Temperaturbedingungen mittels einer Testvorrichtung bekannt, wobei die Kontaktiervorrichtung eine Mehrzahl von Kontaktelementen aufweist und die Kontaktiervorrichtung eine Mehrzahl voneinander getrennter Fluidkanäle zum Zuführen eines temperierten Fluids zu den Kontaktelementen beinhaltet, wobei die Fluidkanäle Nuten umfassen, die in eine die Kontaktelemente seitlich umgebende Wand der Kontaktiereinrichtung eingebracht und mittels eines Deckelteils abgedeckt sind.

Hiervon ausgehend, liegt der Erfindung die Aufgabe zugrunde, eine Kontaktiervorrichtung der eingangs genannten Art zu schaffen, die bei möglichst einfacher und kostengünstiger Herstellung eine sehr genaue Temperierung der Kontaktelemente und damit ein sehr genaues Testen der Bauelemente unter bestimmten Temperaturbedingungen ermöglicht, ohne den rückseitigen Bereich der Kontaktelemente durch eine Temperierungseinrichtung zu besetzen.

Diese Aufgabe wird erfindungsgemäß durch eine Vorrichtung gemäß dem Anspruch 1 gelöst. Vorteilhafte Ausführungsformen der Erfindung sind in den abhängigen Ansprüchen beschrieben.

Die erfindungsgemäße Kontaktiervorrichtung weist eine Mehrzahl voneinander getrennter Fluidkanäle zum gezielten Zuführen des temperierten Fluids zu den Kontaktelementen auf, wobei die Fluidkanäle Nuten umfassen, die in eine die Kontaktelemente seitlich umgebende Wand der Kontaktiervorrichtung eingebracht und mittels eines Deckelteils abgedeckt sind, wobei sich die Fluidkanäle bis zu einem Bereich erstrecken, in dem einzelne Reihen der Kontaktelemente angeordnet sind, so dass die Kontaktelemente die Fluidkanäle durchstoßen, um diese Kontaktelemente mittels separater, temperierter Fluidströme, zu temperieren.

Der Erfindung liegt somit der Gedanke zugrunde, gegebenfalls zusätzlich zur üblichen Temperierung der Bauelemente, die innerhalb des Handhabungsautomaten durch Konvektion und/oder Wärmeleitung erfolgt, die Kontaktelemente mittels separater, temperierter Fluidströme, die über eine Mehrzahl voneinander getrennter Fluidkanäle gezielt einzelnen Kontaktelementen oder Kontaktelementgruppen zugeführt werden, derart zu temperieren, dass sich die Kontaktelemente trotz ihrer Verbindung zu der auf Raumtemperatur temperierten Testvorrichtung genau auf der gewünschten Testtemperatur befinden. Werden die Bauelemente auf die Kontaktelemente aufgesetzt, erfolgt somit keine Änderung der Temperatur des Halbleiterplättchens innerhalb des Bauelements, so dass die gewünschte Temperatur der Bauelemente während des Testvorgangs gehalten und die Testvorgänge auf sehr genaue Weise durchgeführt werden können. Dies ist insbesondere bei Kontaktiervorrichtungen zum Testen von Bauelementen vorteilhaft, die im Hochfrequenzbereich eingesetzt werden, da dort üblicherweise sehr kurze, gerade, längenveränderliche Kontaktstifte mit Federung (sogenannte Pogo-Pins) eingesetzt werden, die ohne separate Zwangstemperierung einen starken Wärmeaustausch zum Halbleiterplättchen der zu testenden Bauelemente verursachen würden. Der rückseitige Bereich der Kontaktelemente wird hierbei nicht durch die Temperierungseinrichtung besetzt. Weiterhin lassen sich die erfindungsgemäßen Fluidkanäle auf relativ einfache und kostengünstige Weise herstellen.

Gemäß einer vorteilhaften Ausführungsform weist die Kontaktiervorrichtung Fluidauslassöffnungen auf, über welche das Fluid zu dem mit den Kontaktelementen kontaktierten Bauelement strömt, um das Bauelement zusätzlich zu temperieren. Dies gewährleistet zusätzlich, dass auch das Bauelement auf der gewünschten Testtemperatur gehalten wird.

Die zusätzliche Temperierung der Bauelemente lässt sich auf relativ einfache Weise dadurch bewerkstelligen, dass die Fluidauslassöffnungen durch Öffnungen der Kontaktiervorrichtung gebildet werden, durch welche sich die Kontaktelemente hindurch erstrecken.

Die Erfindung wird nachfolgend anhand der Zeichnungen beispielhaft näher erläutert. Es zeigen:
- Figur 1 :: eine Explosionsdarstellung einer erfindungsgemäßen Kontaktiervorrichtung in der Form eines Kontaktsockels mit handlerseitigem Deckelteil;
- Figur 2 :: den Kontaktsockel und das Deckelteil von Figur 1 in montiertem Zustand;
- Figur 3 :: eine handlerseitige Ansicht des Kontaktsockels von Figur 2;
- Figur 4 :: einen Schnitt längs der Linie IV-IV von Figur 3;
- Figur 5 :: eine handlerseitige Ansicht des Kontaktsockels von Figur 1 ohne Deckelteil;
- Figur 6 :: eine testerseitige Ansicht des Deckelteils von Figur 1 mit daran angrenzenden Teilen einer Luftversorgungseinrichtung;
- Figur 7 :: eine Seitenansicht des Deckelteils und der Luftversorgungseinrichtung von Figur 6;
- Figur 8 :: eine Explosionsdarstellung des Kontaktsockels von Figur 1 und eines testerseitigen Deckelteils von der Seite der Testvorrichtung her;
- Figur 9 :: den Kontaktsockel und das Deckelteil von Figur 8 in montiertem Zustand;
- Figur 10 :: eine Schnittdarstellung durch den Kontaktsockel und das Deckelteil von Figur 9 im Bereich zweier Kontaktelemente; und
- Figur 11 :: eine schematische Darstellung einer Kontaktiervorrichtung und des angrenzenden Teils eines Handhabungsautomaten gemäß dem Stand der Technik.

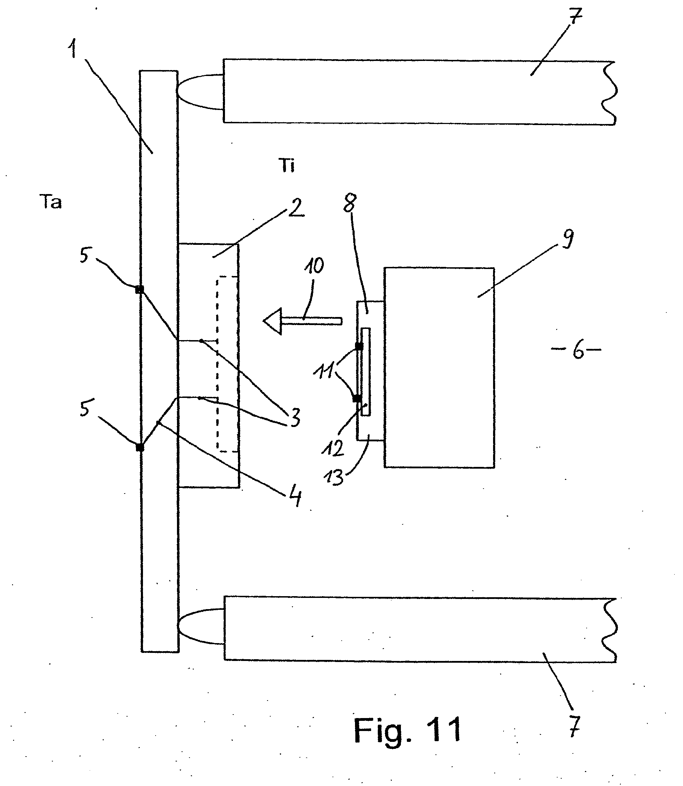

Aus Figur 11 ist schematisch eine Kontaktiervorrichtung gemäß dem Stand der Technik im Übergangsbereich zum Handhabungsautomaten ersichtlich. Die Kontaktiervorrichtung besteht aus einem Kontaktierboard 1, an dem handlerseitig ein Kontaktsockel 2 befestigt ist. Der Kontaktsockel 2 weist durchgehende Kontaktelemente 3 (Kontaktpins) auf. Die Kontaktelemente 3 sind testerseitig mit Leitungen 4 verbunden, die durch das Kontaktierboard 1 hindurchgeführt sind und testerseitig, d.h. in Figur 11 auf der linken Seiten des Kontaktierboards 1, in Kontakten 5 enden. Die Kontakte 5 sind mit nicht dargestellten Leitungen verbindbar, die zur Testvorrichtung führen. Auf der linken Seite des Kontaktierboards 1, d.h. testerseitig, herrscht die Außentemperatur Ta, die der Raumtemperatur entspricht.

Die Kontaktiervorrichtung von Figur 11 wird an einem Handhabungsautomaten angekoppelt, von dem nur der vordere Teil einer Temperaturkammer 6 mit äußeren isolierenden Wänden 7 dargestellt ist. Die Temperaturkammer 6 wird nach vorne durch das Kontaktierboard 1 verschlossen. Im Inneren der Temperaturkammer 6 herrscht die Innentemperatur Ti, die beispielsweise von -60° bis +160°C reichen kann. Ein zu testendes Bauelement 8 ist in einem Nest 9 gehaltert, das mittels eines nicht dargestellten Kolbens in Richtung des Pfeils 10 an den Kontaktsockel 2 herangefahren werden kann, bis Anschlusskontakte 11 des Bauelements 8, beispielsweise Beinchen, Pads oder Balls, auf den Kontaktelementen 3 des Kontaktsockels 2 aufgesetzt sind. In diesem Zustand kann dann das Bauelement 8 von der Testvorrichtung getestet werden. Nach Beendigung des Tests wird das Nest 9 mit dem Bauelement 8 mittels des Kolbens wieder vom Kontaktsockel 2 entfernt. Weiterhin ist in Figur 11 noch schematisch ein Halbleiterplättchen 12 ("Die") dargestellt, das von einer Bauelementummantelung 13 umgeben ist.

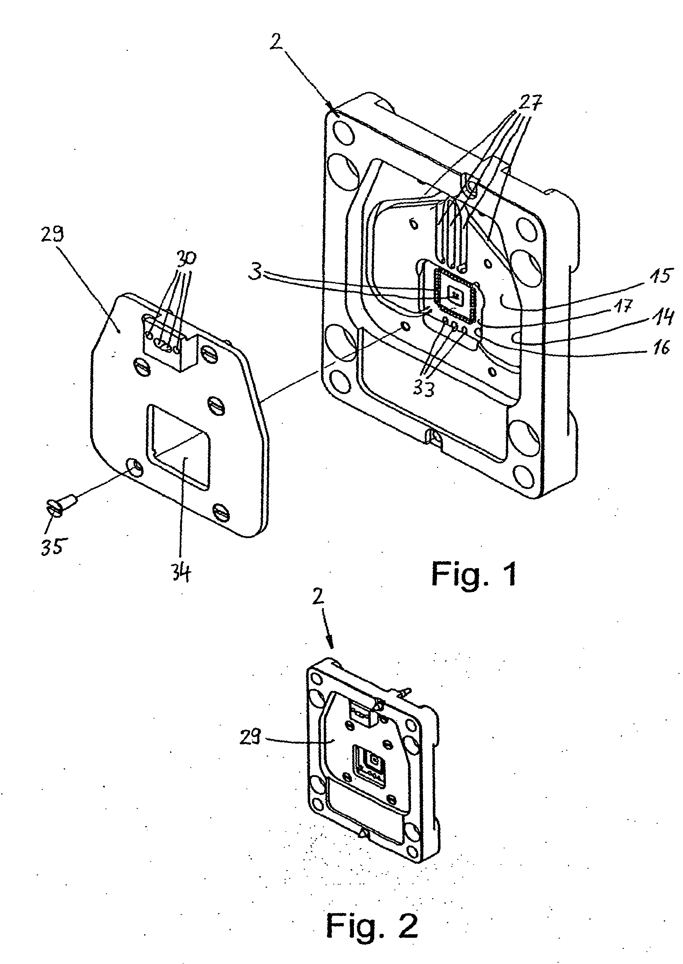

Im Folgenden wird anhand der Figuren 1 bis 10 eine bevorzugte Ausführungsform der erfindungsgemäßen Kontaktiervorrichtung beschrieben.

Wie aus den Figuren 1 bis 3 und 5 ersichtlich, welche die erfindungsgemäße Kontaktiervorrichtung von der Seite des Handhabungsautomaten her zeigen, weist der im Wesentlichen rechteckige Kontaktsockel 2 eine Aussparung 14 auf, die durch eine zurückversetzte Wand 15 abgeschlossen ist. In der Wand 15 befindet sich eine zentrale Vertiefung 16, die durch einen zentralen Wandabschnitt 17 abgeschlossen ist.

Im Wandabschnitt 17 sind vier Reihen von Kontaktelementen 3 gehaltert, die zusammen einen geschlossenen, viereckigen Ring ergeben. Weiterhin sind in der Mitte dieses Rings vier weitere Kontaktelemente 3 angeordnet. Die Kontaktelemente 3 stehen in Richtung des Handhabungsautomaten, d.h. in Figur 1 nach links, geringfügig über den Wandabschnitt 17 vor, so das ein nicht dargestelltes, zu testendes elektronisches Bauelement mit seinen Anschlusskontakten 11 auf die zugehörigen Kontaktelemente 3 aufgesetzt werden kann.

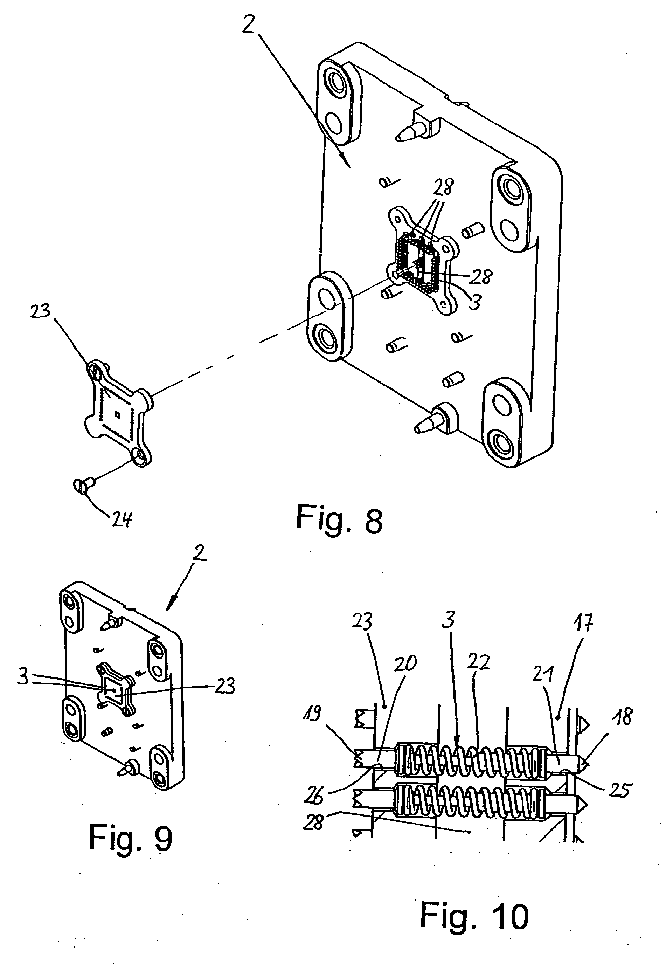

Bei den Kontaktelementen 3 kann es sich beispielsweise um gerade, längenveränderliche Kontaktstifte mit Federung (Pogo-Pins) handeln, wie sie in Figur 10 dargestellt sind. Diese Kontaktelemente 3 weisen eine handlerseitige Kontaktspitze 18 und eine testerseitige Kontaktkrone 19 auf. Auf die Kontaktspitzen 18 können die Anschlusskontakte 11 des Bauelements 8 (vgl. Figur 11) aufgesetzt werden, während die Kontaktkronen 19 mit den Leitungen 4 kontaktiert werden können, die sich durch das Kontaktierboard 1 hindurcherstrecken. Ein hinterer Kontaktelementabschnitt 20 ist längsverschiebbar (teleskopisch) innerhalb eines vorderen Kontaktelementabschnitts 21 geführt, wobei die Vorspannkraft einer dazwischen angeordneten Feder 22 bewirkt, dass die beiden Kontaktelementabschnitte 20, 21 auseinander gehalten werden. Diese Kontaktelemente 3 können somit einfedern, wenn die Anschlusskontakte 11 der Bauelemente 8 auf die Kontaktspitzen 18 aufgesetzt werden, so dass sie sich entsprechend anpassen können, wenn die Anschlusskontakte 11 der Bauelemente 8 nicht alle in der gleichen Ebene liegen.

Derartige Kontaktelemente 3 können sehr klein und mit geringer Länge von wenigen mm ausgeführt werden, so dass sie insbesondere für Hochfrequenzmessungen eingesetzt werden. Sowohl die beiden Kontaktelementabschnitte 20, 21 als auch die Feder 22 bestehen dabei zweckmäßigerweise aus einem gut leitenden Material.

Wie aus den Figuren 8 bis 10 ersichtlich, sind die Kontaktelemente 3 mit ihrem vorderen Kontaktelementabschnitt 20 im zentralen Wandabschnitt 17 des Kontaktsockels 2 längsverschiebbar gelagert, während sie mit ihrem hinteren Kontaktelementabschnitt 20 in einem testerseitigen Deckelteil 23 gelagert sind, das mittels Schrauben 24 am Kontaktsockel 2 festgeschraubt werden kann. Hierbei weist, wie aus Figur 10 ersichtlich, der zentrale Wandabschnitt 17 für jedes Kontaktelement 3 eine gestufte Bohrung 25 auf, während das Deckelteil 23 eine hierzu fluchtende, gestufte Bohrung 26 aufweist.

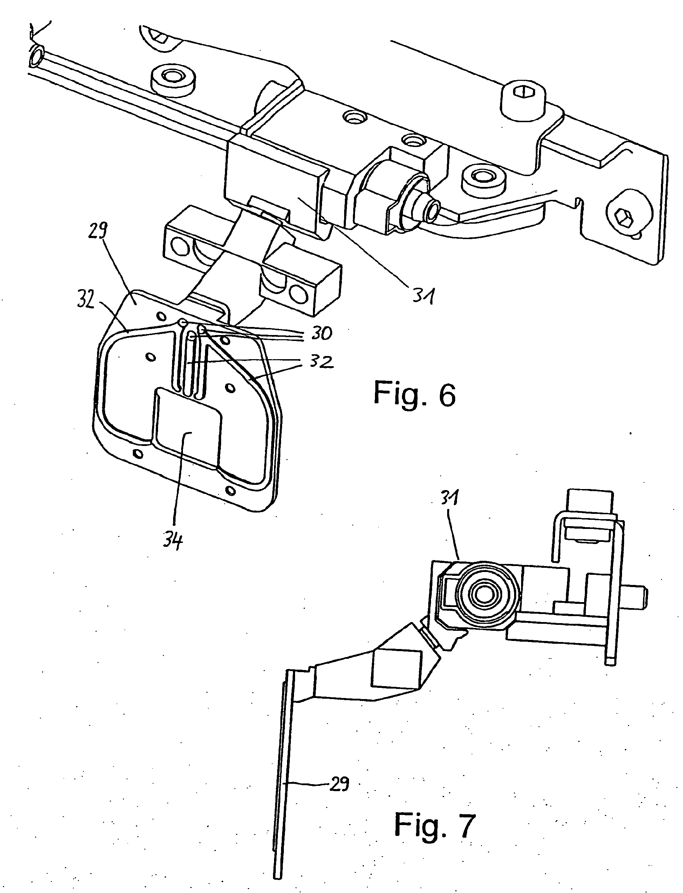

Wie insbesondere aus den Figuren 1, 5 und 8 ersichtlich, weist der Kontaktsockel 2 eine Mehrzahl von handlerseitigen Fluidkanälen 27 und testerseitigen Fluidkanälen 28 auf. Die handlerseitigen Fluidkanäle 27 bestehen zumindest größtenteils aus Nuten, die von der Handlerseite her in die Wand 15 eingebracht und mittels eines handlerseitigen Deckelteils 29 abgedeckt sind. In ihrem oberen Endbereich stehen die Fluidkanäle 27 mit Fluidzuführkanälen 30 in Fluidverbindung, welche durch das Deckelteil 29 hindurchgeführt sind. Die Fluidzuführkanäle 30 stehen wiederum mit einer Fluidzuführleitung einer Fluidversorgungseinrichtung 31 in Fluidverbindung, von der in Figur 6 nur der dem Deckelteil 29 benachbarte Abschnitt dargestellt ist.

Das Deckelteil 29 ist in die Aussparung 14 derart einsetzbar, dass es die Fluidleitungen 27 überdeckt und dadurch in Richtung des Handhabungsautomaten abdichtet. Diese Abdichtung wird, wie aus Figur 6 ersichtlich, zusätzlich durch erhabene Stege 32 unterstützt, die entsprechend dem Verlauf der Fluidkanäle 27 verlaufen, jedoch über die benachbarte ebene Wand des Deckelteils 29 wesentlich weniger weit vorstehen, als die Fluidkanäle 27 tief sind.

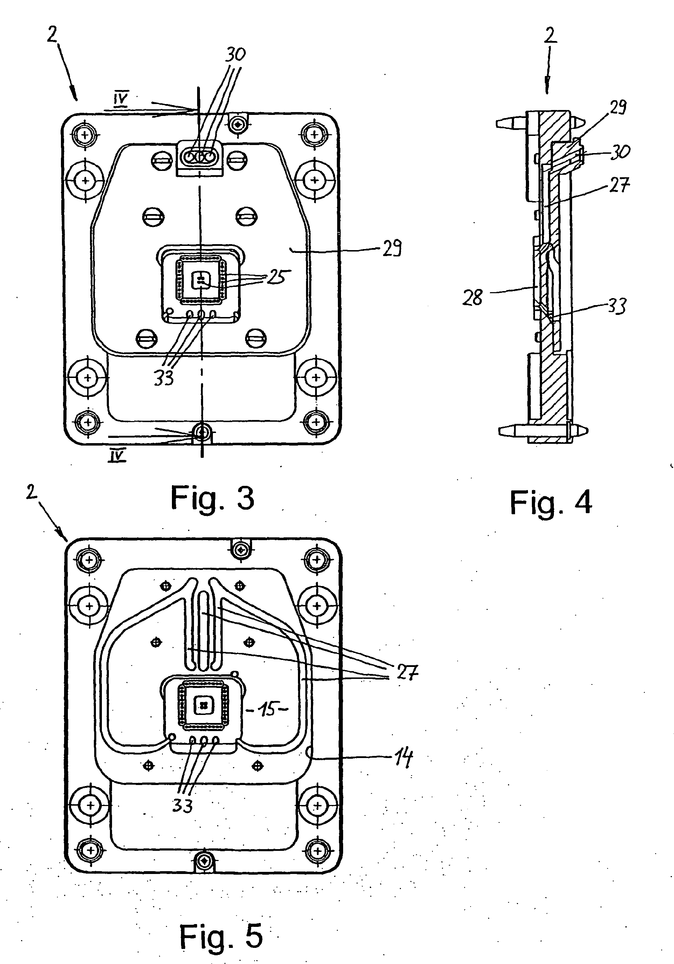

Wie aus den Figuren 1 und 5 ersichtlich, verlaufen zwei Fluidkanäle 27 zu den beiden unteren Eckbereichen der zentralen Vertiefung 16, während drei vertikale Fluidkanäle 27 die Wand 15 durchdringen und mit den testerseitigen Fluidkanälen 28 (Figuren 8, 10) in Fluidverbindung stehen.

Die testerseitigen Fluidkanäle 28 sind so angeordnet, dass die Kontaktelemente 3 von einem temperierten Fluid, das über die Fluidzuführkanäle 30 und die Fluidkanäle 27 zugeführt wird, direkt umströmt werden, wie aus Figur 10 ersichtlich. Dies kann beispielsweise dadurch erfolgen, dass die Fluidkanäle 28 genau dort angeordnet sind, wo die einzelnen Reihen der Kontaktelemente 3 verlaufen, so dass alle Kontaktelemente 3 Fluidkanäle 28 durchstoßen.

Das Abführen des temperierten Fluids aus den Fluidkanälen 27, 28 kann über Fluidauslassöffnungen 33 erfolgen (Figuren 1 bis 5), welche den zentralen Wandabschnitt 17 durchdringen und einerseits mit den testerseitigen Fluidkanälen 28 in Fluidverbindung stehen und andererseits in die zentrale Vertiefung 16 münden, so dass das Fluid von dort über eine zentrale Öffnung 34 des Deckelteils 29 in die Isolierkammer 6 des Handhabungsautomaten abströmen kann. Die Öffnung 34 des Deckelteils 29 ist in Form und Größe an die zentrale Vertiefung 16 des Kontaktsockels 2 angepasst und fluchtend zu dieser angeordnet, so dass das zu testende Bauelement 8 durch die Öffnung 34 hindurch auf die Kontaktelemente 3 aufgesetzt werden kann. Das Deckelteil 29 wird mittels Schrauben 35 an der Wand 15 des Kontaktsockels 2 festgeschraubt.

Wie aus Figur 10 ersichtlich, können die Bohrungen 25, in denen die Kontaktelemente 3 im zentralen Wandabschnitt 17 des Kontaktiersockels 2 gelagert sind, einen größeren Durchmesser als der Außendurchmesser der Kontaktelement 3 in diesem Bereich aufweisen. Hierdurch kann erreicht werden, dass temperiertes Fluid, das über den Fluidkanal 28 zu den Kontaktelementen 3 geleitet wird, über die Bohrungen 25 in Richtung des kontaktierten Bauelements 8 strömen kann, so dass auch die Anschlusskontakte 11 des Bauelements 8 zusätzlich über das austretende Fluid temperiert werden.

Die Temperierung des Fluids wird zweckmäßigerweise über einen separaten Regelkreis geregelt, mit dem die Temperatur des Fluids unabhängig von der im Handhabungsautomaten durchgeführten Temperierung der Bauelemente 8 geregelt und an die jeweiligen Erfordernisse angepasst werden kann. Weiterhin kann auch der Druck des zur Kontaktiervorrichtung geleiteten Fluids entsprechend den jeweiligen Erfordernissen angepasst werden. Durch eine verschieden große Dimensionierung der Fluidkanäle 27, 28 ist es möglich, die zu einzelnen Bereichen der Kontaktiervorrichtung geleitete Fluidmenge einzustellen.

Beim Fluid kann es sich bekanntermaßen beispielsweise um temperierte, getrocknete Luft oder um Stickstoff handeln.

## Patentansprüche

1. Kontaktiervorrichtung zum elektrischen Testen von elektronischen Bauelementen unter bestimmten Temperaturbedingungen mittels einer Testvorrichtung, mit folgenden Merkmalen:
- die Kontaktiervorrichtung ist zwischen der Testvorrichtung und einem Handhabungsautomaten für die Bauelemente angeordnet,
- die Kontaktiervorrichtung weist eine Mehrzahl von Kontaktelementen (3) auf, die einerseits mit der Testvorrichtung elektrisch verbunden sind und mit denen andererseits Anschlusskontakte (11) der zu testenden Bauelemente (8) in Kontakt bringbar sind,
- die Kontaktiervorrichtung ist über eine Fluidzuführleitung mit einer Fluidversorgungseinrichtung (31) in Fluidverbindung und weist eine Mehrzahl voneinander getrennter Fluidkanäle (28) zum Zuführen eines temperierten Fluids zu den Kontaktelementen (3) auf, wobei die Fluidkanäle (27) Nuten umfassen, die in eine die Kontaktelemente (3) seitlich umgebende Wand (15) der Kontaktiereinrichtung eingebracht und mittels eines Deckelteils (29) abgedeckt sind,
**dadurch gekennzeichnet, dass** sich die Fluidkanäle (28) bis zu einem Bereich erstrecken, in dem einzelnes Reihen der Kontaktelemente (3) angeordnet sind, so dass die Kontaktelemente (3) die Fluidkanäle (28) durchstoßen um diese Kontaktelemente mittels separater, temperierter Fluidströme, zu temperieren.

2. Kontaktiervorrichtung nach Anspruch 1, **dadurch gekennzeichnet, dass** die Fluidkanäle (27, 28) über mindestens einen im Deckelteil (29) angeordneten Fluidzuführkanal (30) mit der Fluidversorgungseinrichtung in Fluidverbindung stehen.

3. Kontaktiervorrichtung nach Anspruch 1 oder 2, **dadurch gekennzeichnet, dass** die Kontaktiervorrichtung Fluidauslassöffnungen (33) aufweist, über welche das Fluid zu dem mit den Kontaktelementen (3) kontaktierten Bauelement (8) strömt, um das Bauelement (8) zusätzlich zu temperieren.

4. Kontaktiervorrichtung nach Anspruch 3, **dadurch gekennzeichnet, dass** die Fluidauslassöffnungen (33) durch Öffnungen der Kontaktiervorrichtung gebildet werden, durch welche sich die Kontaktelemente (3) hindurch erstrecken.

5. Kontaktiervorrichtung nach einem der vorhergehenden Ansprüche, **dadurch gekennzeichnet, dass** die Kontaktelemente (3) aus geraden, längenveränderlichen Kontaktstiften mit Federung (Pogo-Pins) bestehen.

6. Kontaktiervorrichtung nach einem der vorhergehenden Ansprüche, **dadurch gekennzeichnet, dass** die Kontaktiervorrichtung mindestens einen Kontaktsockel (2) und ein Kontaktierboard (1) umfasst, an dem der Kontaktsockel (2) befestigt ist.

## Claims

1. Contacting device for electrically testing electronic components under specified temperature conditions using a test device, having the following features:
- the contacting device is arranged between the test device and an automatic handling device for the components,
- the contacting device comprises a plurality of contact elements (3), which are electrically connected to the test device, on the one hand, and with which connecting contacts (11) of the components (8) to be tested can be brought into contact, on the other hand.
- the contacting device is in fluid communication with a fluid supply means (31) via a fluid feed line and comprises a plurality of mutually separated fluid channels (28) for supplying a temperature-controlled fluid to the contact elements (3), the fluid channels (27) comprising grooves which are formed in a wall (15) of the contacting means, which wall laterally surrounds the contact elements (3), and are covered by a cover part (29),
**characterised in that** the fluid channels (28) extend to a region in which individual rows of contact elements (3) are arranged in such a way that the contact elements (3) pierce through the fluid channels (28) to provide temperature control of these contact elements by means of separate, temperature-controlled streams of fluid.

2. Contacting device according to claim 1, **characterised in that** the fluid channels (27, 28) are in fluid communication with the fluid supply means via at least one fluid supply channel (30) arranged in the cover part (29).

3. Contacting device according to either claim 1 or claim 2, **characterised in that** the contacting device comprises fluid outlet openings (33), via which the fluid flows to the component (8) contacted by the contact elements (3) in order to provide additional temperature control of the component (8).

4. Contacting device according to claim 3, **characterised in that** the fluid outlet openings (33) are formed by openings in the contacting device, through which the contact elements (3) extend.

5. Contacting device according to any one of the preceding claims, **characterised in that** the contact elements (3) consist of straight, spring-loaded contact pins of variable length (pogo pins).

6. Contacting device according to any one of the preceding claims, **characterised in that** the contacting device comprises at least a contact base (2) and a contact board (1) to which the contact base (2) is fixed.

## Revendications

1. Dispositif de mise en contact pour tester électriquement des composants électroniques sous des conditions de température déterminées au moyen d'un appareil de test, présentant les éléments suivants :
- le dispositif de mise en contact est agencé entre l'appareil de test et un automate de manipulation pour les composants,
- le dispositif de mise en contact comporte une pluralité d'éléments de contact (3) qui sont d'une part en liaison électrique avec l'appareil de test et qui peuvent d'autre part être amenés en contact avec des contacts de connexion (11) des composants (8) à tester,
- le dispositif de contact est en communication fluidique via une conduite d'amenée de fluide avec un système d'alimentation de fluide (31) et comporte une pluralité de canaux à fluide (28) séparés les uns des autres pour l'amenée d'un fluide tempéré aux éléments de contact (3), dans lequel les canaux à fluide (27) comportent des gorges qui sont ménagées dans une paroi (15) du dispositif de mise en contact entourant les éléments de contact (3), et qui sont recouvertes au moyen d'une partie formant couvercle (29),
**caractérisé en ce que** les canaux à fluide (28) s'étendent jusqu'à une région dans laquelle sont agencées des rangées individuelles d'éléments de contact (3), de sorte que les éléments de contact (3) traversent les canaux à fluide (28) afin de tempérer ces éléments de contact au moyen de courants de fluide tempérés séparés.

2. Dispositif de mise en contact selon la revendication 1, **caractérisé en ce que** les canaux à fluide (27, 28) sont en communication fluidique avec le système d'alimentation de fluide via au moins un canal d'amenée de fluide (30) agencé dans la partie formant couvercle (29).

3. Dispositif de mise en contact selon la revendication 1 ou 2,
**caractérisé en ce que** le dispositif de mise en contact comporte des ouvertures de sortie de fluide (33) via lesquelles s'écoule le fluide vers le composant (8) en contact avec les éléments de contact (3), afin de tempérer additionnellement le composant (8).

4. Dispositif de mise en contact selon la revendication 3, **caractérisé en ce que** les ouvertures de sortie de fluide (33) sont formées par des ouvertures du dispositif de mise en contact à travers lesquelles s'étendent les éléments de contact (3).

5. Dispositif de mise en contact selon l'une des revendications précédentes, **caractérisé en ce que** les éléments de contact (3) sont des tiges de contact à longueur variable avec support élastique ("Pogo-Pins).

6. Dispositif de mise en contact selon l'une des revendications précédentes, **caractérisé en ce que** le dispositif de mise en contact comprend au moins un socle de contact (2) et une plaque de mise en contact (1) sur laquelle est fixé le socle de contact (2).
